# EUROPÄISCHE PATENTSCHRIFT

(11) **EP 0 951 810 B1**
(45) Veröffentlichungstag und Bekanntmachung des Hinweises auf die Patenterteilung: **10.04.2002**
(21) Anmeldenummer: 98904022.5
(22) Anmeldetag: 13.01.1998
(51) Int. Cl.: H05K 13/02, H05K 13/04

(54) **EINRICHTUNG ZUM ZUFÜHREN VON ELEKTRISCHEN BAUTEILEN AN EINEN BESTÜCKAUTOMATEN**
DEVICE FOR FEEDING ELECTRIC COMPONENTS INTO INSERTION MACHINES
DISPOSITIF D'AMENEE DE COMPOSANTS ELECTRIQUES A UNE MACHINE D'INSERTION AUTOMATIQUE

(30) Priorität: 13.01.1997 DE 19700840
(43) Veröffentlichungstag der Anmeldung: 27.10.1999
(73) Patentinhaber: SIEMENS AKTIENGESELLSCHAFT, 80333 München (DE)
(72) Erfinder: BARNOWSKI, Frank, D-81475 München (DE); MEHDIANPOUR, Mohammad, D-81829 München (DE)
(86) Internationale Anmeldenummer: DE9800112
(87) Internationale Veröffentlichungsnummer: WO9831207

(56) Entgegenhaltungen:
- EP-A- 0 277 732
- DE-U- 9 216 116

## Beschreibung

Die Erfindung bezieht sich auf eine Einrichtung zum Zuführen von elektrischen Bauteilen an einen Bestückautomaten zum Aufsetzen der Bauteile auf Leiterplatten.

Es ist üblich, die Bauteile in Gurten zu fassen, die als aufgewickelte Spulen geliefert werden. Diese Spulen werden bedarfsweise in einer Zufüheinrichtung zusammengestellt und aneinandergereiht. Jeder Spule ist ein passendes Zuführmodul zugeordnet, in das der Bauteilegurt hineingeführt ist. Die Zuführmodule sind in der gleichen Konfiguration wie die Spulen aneinander gereiht und auf einem tischartigen Träger der Zufüheinrichtung fixiert. Der Bestückautomat und der Träger sind mit wechselseitig angeordneten Zentriermitteln versehen, die eine genaue Zuordnung der Zuführmodule zum Bestückautomaten ermöglichen.

Eine derartige, z.B. durch die EP-B1-0 373 373 bekannte Konfiguration mit feststehenden Zuführmodulen erfordert einen Bestückautomaten mit einem x-y-verfahrbaren Bestückkopf, dessen Abholgreifer zu den einzelnen Abholstellen der verschiednen Zuführmodule verfahrbar ist. Da der Verfahrweg eines solchen Bestückkopfes möglichst kurz sein soll, ist die Anzahl der Zuführmodule einer Zuführeinrichtung beschränkt, so daß die Zufüheinrichtung relativ häufig gewechselt werden muß.

Die Zufüheinrichtung ist dem Bestückautomaten lösbar zugeordnet. Sie kann also zusammen mit den Spulen und den Zuführmodulen in einem Arbeitsgang ausgewechselt werden, so daß die Umrüstzeiten entsprechend kurz sind.

Bisher war es üblich, die gestellartige Zufüheinrichtung mittels eines Hubwagens zu transportieren. Dieser ermöglicht es, den tischartigen, in einer oberen Stellung fixierten Träger von oben her auf eine Aufnahme des Bestückautomaten abzusenken und dabei mit Hilfe der Zentriermitteln genau zu zentrieren.

Durch die EP 0 277 732 A ist eine karusselartige Zufüheinrichtung bekannt, deren Zuführmodule auf einem tischartigen Träger gehalten sind, der um eine senkrechte Achse schwenkbar gelagert ist. Die Zufüheinrichtung ist auf Rädern verfahrbar. An ihrer dem Bestückautomaten zugewandten senkrechten Seite der Zufüheinrichtung sind in der Fahrrichtung weisende Zentriermittel vorgesehen, die in entsprechende Gegenzentriermittel des Bestückautomaten in waagerechter Richtung einsetzbar sind. Zwischen den Rädern und einem Chassis der Zufüheinrichtung ist eine Verstelleinrichtung angeordnet, durch die die Höhenlage der Zentriermittel mittels einer Stellschraube auf die Höhe der Gegenzentriermittel des Bestückautomaten einstellbar sind. Da die Zufüheinrichtung eine sehr großen Anzahl von Spulen aufnehmen kann, muß die Zuführeinrichtung relativ selten gewechselt werden, so daß der hohe Zeitaufwand bei der Höhenverstellung nur eine geringe Bedeutung hat.

Ferner ist durch die DE 85 25 978 U (=US 4 593 462)eine Zuführeinrichtung bekannt die ebenfalls waagerecht orientierte Zentriermittel aufweist. Ein Aufnahmekasten für die leeren Bänder ist mittels eines Kniehebelantriebs kippbar gelagert, um eine Einführöffnung für die Bänder freigeben zu können.

Der Erfindung liegt die Aufgabe zugrunde, die Handhabung der Zufüheinrichtung zu erleichtern. Diese Aufgabe wird durch die Erfindung gemäß Anspruch 1 gelöst.

Dadurch ist es möglich, die Zuführeinrichtung unabhängig von anderen Hilfsmitteln zu transportieren und zu betätigen. Die Hubeinrichtung ermöglicht es, den Träger mit den Zuführmodulen gesondert anzuheben und z.B. über nach oben ragende Zentrierstifte der Aufnahme des Bestückautomaten zu verfahren. Durch Absenken der Hubeinrichtung wird sodann der Träger auf die Aufnahme aufgelegt, wobei die Zentriermittel ineinandergreifen. Die pneumatisch betätigbare Hubeinrichtung ist in sich seitlich auslenkbar und kann somit einen gegenseitigen Versatz der Zentriermittel vor dem Absenken aufnehmen, ohne daß dazu eine gelenkige Lagerung der Hubeinrichtung erforderlich ist. Die mit Spiel versehene vertikale Führung ermöglicht es, die Zuführeinrichtungen mit geringer Genauigkeit am Bestückautomaten zu positionieren. Die mit seitlichem Spiel versehene schwimmende Lagerung des Trägers ermöglicht es, diesen dennoch genau am Bestückautomaten zu zentrieren. Dadurch ist es möglich, auf die störenden Hubwagen zu verzichten und die Umrüstzeiten zu verkürzen.

Vorteilhafte Weiterbildungen der Erfindung sind in den Unteransprüchen gekennzeichnet.

Der Balgzylinder nach Anspruch 2 stellt ein einfaches und leicht betätigbares und steuerbares Antriebselement dar, durch das der Träger mit den Modulen in einfacher Weise abgesenkt und angehoben werden kann. Der Druckluftanschluß ermöglicht es, die an den Bestückautomaten ohnehin vorhandene Druckluftversorgung für den Hubvorgang zu nutzen.

Durch die Arretierung nach Anspruch 3 ist es möglich, den tischartigen Träger mit den Modulen in seiner höchsten Stellung zu fixieren, ohne daß dafür eine äußere Einwirkung notwendig ist. Auf diese Weise kann die Zuführeinrichtung absenkbereit an den Bestückautomaten angesetzt werden. Zum Absenken wird der Balgzylinder an die Druckluftzufuhr des Automaten angeschlossen und mit Druckluft beaufschlagt. Der tischartige Träger wird dadurch in der oberen Stellung gehalten, so daß die entlastete Arretierung mühelos gelöst werden kann. Ein Entlüftungsventil ermöglicht nun das sanfte Absenken des Trägers auf die Aufnahme des Bestückautomaten, wobei die Zentriermittel in gegenseitigen Eingriff gelangen. Beim Entfernen der Zuführeinrichtung wird zunächst der Balgzylinder mit Druckluft beaufschlagt und der Träger angehoben. Sodann wird der Träger in der oberen Stellung arretiert, in der er bis zum erneuten Andocken am Bestückautomaten verbleibt.

Zum Auswechseln der Zuführeinrichtung wird der Balgzylinder wieder mit Druckluft beaufschlagt und der Träger in seine Höchststellung angehoben, in der die Arretiermittel leicht in ihre Arretierstellung gebracht werden können. Der Balgzylinder wird nun entlüftet und von der Druckluftzufuhr getrennt. Der tischartige Träger wird dann durch die Arretierung in seiner oberen Stellung gehaltgen. Die Zuführeinrichtung kann nun vom Bestückautomaten entfernt und durch eine bereitstehende andere Zuführeinrichtung in gleicher Weise ersetzt werden.

Die Weiterbildungen nach den Ansprüchen 4 und 5 ermöglichen eine einfache Handhabung, wobei insbesondere die Arretierung bequem über den Schiebegriff betätigt werden kann.

Im folgenden wird die Erfindung anhand eines in der Zeichnung dargestellten Ausführungsbeispieles näher erläutert.
- Figur 1: zeigt eine Seitenansicht einer Zuführeinrichtung für elektrische Bauelemente zu einem Bestückautomaten,
- Figur 2: eine andere Seitenansicht der Einrichtung nach Figur 1.

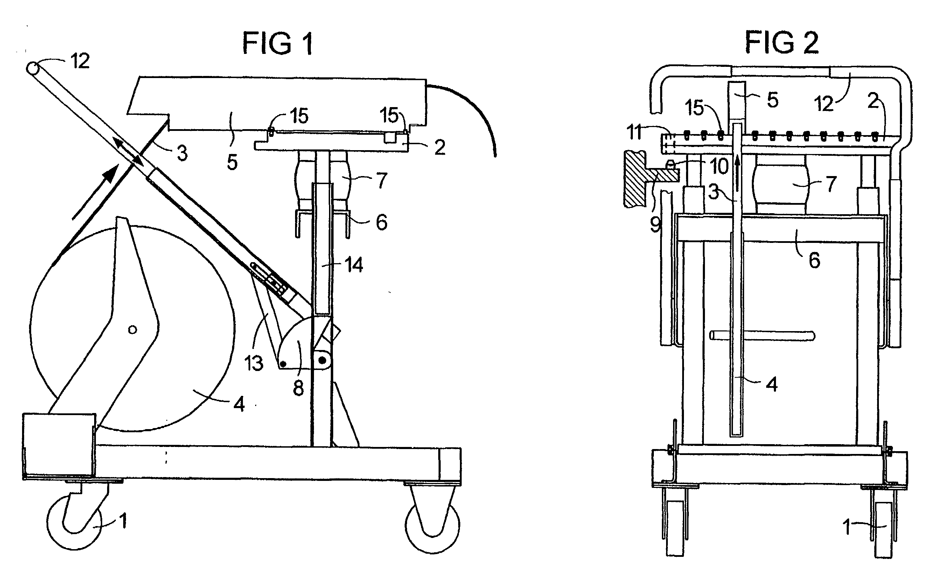

Nach den Figuren 1 und 2 ist eine Zuführeinrichtung zum Zuführen von elektrischen Bauelementen zu einem Bestückautomaten handwagenartig ausgebildet und mit Rädern 1 versehen, die ein lenkbares Fahrwerk bilden. Ein tischartiger Träger 2 ist an einem Gestell der Zuführeinrichtung gehalten, das mit einer teleskopartigen Hubeinrichtung für den Träger 2 versehen ist. Die elektrischen Bauteile sind in Gurten 3 magaziniert, die als aneinanderreihbare Spulen 4 bereitgehalten sind. Auf dem tischartigen Träger 2 sind Zuführmodule 5 in der gleichen Konfiguration wie die Spulen 4 nebeneinander an Halte- und Zentrierelementen 15 befestigbar. Die Gurte 3 sind durch die Zuführmodule 5 hindurchgeführt, in denen die Bauteile freigelegt und zur Entnahme durch einen Greifer des Bestückautomaten bereitgehalten werden.

Zwischen dem tischartigen Träger 2 und einem festen Stützteil 6 der Zuführeinrichtung ist ein Balgzylinder 7 angeordnet, der ein druckluftbetätigtes Anheben und Absenken des Trägers 2 ermöglicht. Dieser ist mit seitlichem Spiel in einer teleskopartigen vertikalen Führung 14 der Zuführeinrichtung geführt. Der Träger 2 befindet sich hier in einer oberen Hubstellung, die durch eine Arretierraste 8 einer Arretiereinrichtung gesichert ist. Der Träger 2 befindet sich oberhalb einer Aufnahme 9 des Bestückautomaten. Der Träger und die Aufnahme 9 sind mit wechselseitig angeordneten Zentrierstiften 10 und Zentrierlöchern 11 versehen, die beim Absenken des Trägers 2 auf die Aufnahme 9 spielfrei ineinander greifen und so die genaue Zuordnung der Zuführmodule 5 zum Bestückautomaten sichern.

Ein Schiebegriff 12 zum Bewegen der Zuführeinrichtung ist am Gestell der Zuführeinrichtung verschiebbar gelagert und kann über eine Schubstange 13 die schwenkbare Arretierraste 8 betägigen.

Der Balgzylinder 7 ist temporär über einen Druckluftanschluß mit der Druckluftversorgung des Bestückautomaten verbindbar und über ein Steuerventil betätigbar. Er ermöglicht das Absenken und Anheben des Trägers 2 mit geringem Bedienaufwand. Der Balgzylinder hat den Vorteil, daß er ohne Gelenklagerung eine seitliche Auslenkung in allen Richtungen ermöglicht. Dadurch kann sich der Träger 2 beim Absenken auf die Aufnahme 9 leicht an dieser zentrieren, ohne daß dazu eine genaue Zuordnung der Zuführeinrichtung zum Bestückautomaten erforderlich ist.

### Bezugszeichen

- 1: Rad
- 2: Träger
- 3: Gurt
- 4: Spule
- 5: Zuführmodul
- 6: Stützteil
- 7: Balgzylinder
- 8: Arretierraste
- 9: Aufnahme
- 10: Zentrierstift
- 11: Zentrierloch
- 12: Schiebegriff
- 13: Schubstange
- 14: Führung
- 15: Zentrierelement

## Patentansprüche

1. Zuführeinrichtung zum Zuführen von elektrischen Bauteilen an einen Bestückautomaten zum Aufsetzen der Bauteile auf Leiterplatten,
wobei die Zuführeinrichtung auf lenkbaren Rädern (1) verfahrbar ist
wobei die Zuführeinrichtung einen tischartigen Träger (2) für Zuführmodule (5) aufweist, mittels derer die Bauteile aus Bauteilemagazinen in eine Abholposition transportierbar sind,
wobei der Träger (2) in einer definierten Stellung auf einer Aufnahme (9) des Bestückautomaten mit Hilfe von Zentriermitteln (z.B. 10, 11) durch senkrechtes Absenken fixierbar ist,
**dadurch gekennzeichnet,**
**daß** die Zuführeinrichtung eine pneumatisch betätigbare, in sich seitlich auslenkbare Hubeinrichtung (7) aufweist und
**daß** der Träger (2) in einer vertikalen Führung (14) der Zuführeinrichtung mit seitlichem Spiel geführt ist.

2. Zuführeinrichtung nach Anspruch 1,
**dadurch gekennzeichnet,**
**daß** die Hubeinrichtung als Balgzylinder (7) ausgebildet ist, der zwischen der Unterseite des Trägers (2) und einem stationären Stützteil (6) der Zuführeinrichtung angeordnet ist und daß die Zuführeinrichtung einen Druckluftanschluß aufweist, der mit einer Druckluftversorgung des Bestückautomaten verbindbar ist.

3. Zuführeinrichtung nach Anspruch 1 oder 2,
**dadurch gekennzeichnet,**
**daß** die Zuführeinrichtung eine Arretierung (z.B. 8) zum Halten des Trägers (7) in einer oberen Hubstellung aufweist.

4. Zuführeinrichtung nach einem der vorhergehenden Ansprüche,
**dadurch gekennzeichnet,**
**daß** die Zuführeinrichtung als von Hand verfahrbarer Wagen ausgebildet ist, der einen Schiebegriff (12) aufweist.

5. Zuführeinrichtung nach Anspruch 4,
**dadurch gekennzeichnet,**
**daß** der Schiebegriff an der Zuführeinrichtung teleskopartig gelagert ist und zumindest eine Arretierraste (8) der Arretierung betätigt.

## Claims

1. Feed device for feeding electrical components to a mounting machine for fitting the components to printed circuit boards, the feed device being displaceable on steerable wheels (1), the feed device having a table-like support (2) for feed modules (5), by means of which the components can be transported out of component magazines into a pick-up position, it being possible to fix the support (2) in a defined position on a mount (9) of the mounting machine with the aid of centring means (e.g. 10, 11), by lowering it vertically, **characterized in that** the feed device has a pneumatically actuable lifting device (7) which can inherently be deflected laterally, and **in that** the support (2) is guided with lateral clearance in a vertical guide (14) of the feed device.

2. Feed device according to Claim 1, **characterized in that** the lifting device is designed as a bellows cylinder (7) which is arranged between the underside of the support (2) and a stationary supporting part (6) of the feed device, and **in that** the feed device has a compressed-air port, which can be connected to a compressed-air supply of the mounting machine.

3. Feed device according to Claim 1 or 2, **characterized in that** the feed device has a locking mechanism (e.g. 8) for holding the support (7) in an upper lifted position.

4. Feed device according to one of the preceding claims, **characterized in that** the feed device is designed as a trolley which can be moved manually and has a sliding handle (12).

5. Feed device according to Claim 4, **characterized in that** the sliding handle is mounted telescopically on the feed device and actuates at least one locking catch (8) of the locking mechanism.

## Revendications

1. Dispositif d'amenée pour amener des composants électriques à une machine d'insertion pour le montage des composants sur des cartes de circuits imprimés,
le dispositif d'amenée pouvant se déplacer sur des roues (1) orientables,
le dispositif d'amenée comprenant un support (2) semblable à une table pour des modules d'amenée (5) au moyen desquels les composants peuvent être transportés depuis des magasins de composants jusqu'à une position d'enlèvement, le support (2) pouvant être fixé, en s'abaissant verticalement, dans une position définie sur un élément de réception (9) de la machine d'insertion à l'aide de moyens de centrage (par exemple 10, 11),
**caractérisé en ce que**
le dispositif d'amenée comprend un dispositif de levage (7) à commande pneumatique qui peut lui-même être dévié latéralement et
**en ce que** le support (2) est guidé, avec un jeu latéral, dans une glissière de guidage (14) verticale du dispositif d'amenée.

2. Dispositif d'amenée selon la revendication 1, **caractérisé en ce que** le dispositif de levage est exécuté en tant que cylindre pneumatique (7) situé entre le côté inférieur du support (2) et un élément de support (6) fixe du dispositif d'amenée, et **en ce que** le dispositif d'amenée est pourvu d'un branchement en air comprimé qui peut être branché sur un dispositif d'alimentation en air comprimé de la machine d'insertion.

3. Dispositif d'amenée selon la revendication 1 ou 2, **caractérisé en ce que** le dispositif d'amenée comprend un dispositif d'arrêt (par exemple 8) pour maintenir le support (2) dans une position de levage haute.

4. Dispositif d'amenée selon l'une des revendications précédentes,
**caractérisé en ce que** le dispositif d'amenée est exécuté en tant que chariot pouvant être déplacé à la main et pourvu d'une poignée de manoeuvre (12).

5. Dispositif d'amenée selon la revendication 4, **caractérisé en ce que** la poignée de manoeuvre est montée de façon télescopique sur le dispositif d'amenée et actionne au moins un cliquet d'arrêt (8) du dispositif d'arrêt.
